(19) **Europäisches Patentamt / European Patent Office / Office européen des brevets**

(11) **EP 3 557 267 A1**

(12) **EUROPEAN PATENT APPLICATION**
published in accordance with Art. 153(4) EPC

(43) Date of publication:
**23.10.2019 Bulletin 2019/43**

(21) Application number: **17881511.4**

(22) Date of filing: **14.12.2017**

(51) Int Cl.:
**G01R 15/18** (2006.01)

(86) International application number:
**PCT/KR2017/014694**

(87) International publication number:
**WO 2018/110991 (21.06.2018 Gazette 2018/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **14.12.2016 KR 20160170647**

(71) Applicant: **Korea Research Institute of Standards and Science**
**Daejeon 34113 (KR)**

(72) Inventors:
• **KIM, Kyu Tae**
  **Daejeon 34145 (KR)**
• **JUNG, Jae Kap**
  **Daejeon 34189 (KR)**

(74) Representative: **Kuhnen & Wacker**
**Patent- und Rechtsanwaltsbüro PartG mbB**
**Prinz-Ludwig-Straße 40A**
**85354 Freising (DE)**

(54) **MULTI-CLAMP MEASUREMENT DEVICE AND CURRENT MEASUREMENT SYSTEM**

(57)     A multi-clamp measurement device according to the present invention comprises: a multi-clamp including a first and a second core configured to output a first and a second magnetic field around a conductor, respectively; and a current measurement controller configured to remove a noise magnetic field around the conductor on the basis of the first and the second magnetic field to detect a current flowing through the conductor.

FIG. 1

# Description

[TECHNICAL FIELD]

The inventive concept relates to a current measurement apparatus, and more particularly, relates to a multi-clamp measurement apparatus and a current measurement system.

[BACKGROUND ART]

An electrical measurement apparatus is a measurement apparatus that measures various characteristics (e.g., a voltage, a current, and a resistance) of electrical elements or electrical devices. In general, various characteristics of electrical elements or electrical devices are detected by directly attaching the measurement apparatus to the electrical elements or the electrical devices.

For example, a current that is provided to an electrical element or an electrical device is measured by cutting an electrical wire (or a conductor) providing the current to the electrical element or the electrical device and connecting a measurement apparatus with the electrical wire thus cut. To solve the issue such as the cutting of an electrical wire, a clamp-type measurement apparatus that measures an electric field (or a magnetic field) generated by a current flowing through the electrical wire is being used.

However, because the clamp-type measurement apparatus does not directly measure a current of an electrical wire but estimates a current based on a magnetic field around the electrical wire, the clamp-type measurement apparatus has a significant influence of a magnetic field by an external factor, and thus, the accuracy of measurement of the current decreases.

[DETAILED DESCRIPTION OF THE INVENTION]

[TECHNICAL PROBLEM]

The inventive concept is for solving the above problem, and an object of the inventive concept provides a multi-clamp measurement apparatus and a current measurement system, which have improving reliability and reduced costs.

[TECHNICAL SOLUTION]

A multi-clamp measurement apparatus according to an embodiment of the inventive concept includes a multi-clamp including first and second cores configured to detect first and second magnetic fields around a conductor, respectively, and a current measurement controller configured to remove a noise magnetic field around the conductor based on the first and second magnetic fields and to detect a current flowing through the conductor.

As an embodiment, each of the first and second magnetic fields includes a component of a current magnetic field generated by the current flowing through the conductor and a component of the noise magnetic field.

As an embodiment, the first core includes a first magnetic sensor measuring the first magnetic field, and the second core includes a second magnetic sensor measuring the second magnetic field.

As an embodiment, the first and second magnetic sensors have a geometric position difference of 180 degrees mutually with respect to the conductor.

As an embodiment, a magnitude of the first magnetic field is a sum of a magnetic field of the current magnetic field and a magnitude of the noise magnetic field, and a magnitude of the second magnetic field is a difference between the magnitude of the current magnetic field and the magnitude of the noise magnetic field.

As an embodiment, the first and second magnetic sensors are disposed at different positions with respect to the conductor, and the current measurement controller is configured to detect the current by performing a vector operation on the first and second magnetic fields such that the noise magnetic field is removed.

As an embodiment, the noise magnetic field includes at least one a magnetic field existing in a natural state, a magnetic field generated by another conductor, or a magnetic field generated by another device.

As an embodiment, the first and second cores are disposed adjacent to each other and are spaced from each other as much as a given distance along the conductor.

As an embodiment, the first and second cores are embedded in one case.

A multi-clamp measurement apparatus according to the inventive concept includes a multi-clamp including a plurality of cores configured to detect magnetic fields around a conductor, respectively, and a current measurement controller configured to remove a noise magnetic field around the conductor based on the plurality of magnetic fields and to detect a current flowing through the conductor.

As an embodiment, each of the plurality of magnetic fields includes a component of a current magnetic field generated by the current flowing through the conductor and a component of the noise magnetic field.

A current measurement system according to an embodiment of the inventive concept includes a first current measurement apparatus configured to measure a first magnetic field around a conductor, a second current measurement apparatus spaced from the first current measurement apparatus as much as a given distance, and configured to measure a second magnetic field around the conductor, and a current measurement controller configured to remove a noise magnetic field around the conductor based on the first and second magnetic fields and to detect a current flowing through the conductor.

[ADVANTAGEOUS EFFECTS OF THE INVENTION]

According to the inventive concept, a micro-current flowing through a conductor may be accurately measured without a separate shielding device. A multi-clamp measurement apparatus according to the inventive concept may be used for various tests of various electric devices such as an electric motor and an electric generator, thus improving the reliability of a test result. Accordingly, a multi-clamp measurement apparatus having improved reliability and reduced costs is provided.

[DESCRIPTION OF THE DRAWINGS]

FIG. 1 is a diagram illustrating a multi-clamp measurement apparatus according to an embodiment of the inventive concept.
FIGS. 2 and 3 are diagrams illustrating a multi-clamp of FIG. 1 in detail.
FIG. 4 is a diagram for describing a multi-clamp according to another embodiment of the inventive concept.
FIG. 5 is a diagram illustrating a configuration of a multi-clamp according to an embodiment of the inventive concept.
FIGS. 6 and 7 are diagrams illustrating a configuration of a multi-clamp according to an embodiment of the inventive concept.
FIG. 8 is a block diagram illustrating a multi-clamp measurement apparatus according to the inventive concept.
FIG. 9 is a block diagram illustrating current measurement system according to an embodiment of the inventive concept.

[BEST MODE FOR CARRYING OUT THE INVENTIVE CONCEPT]

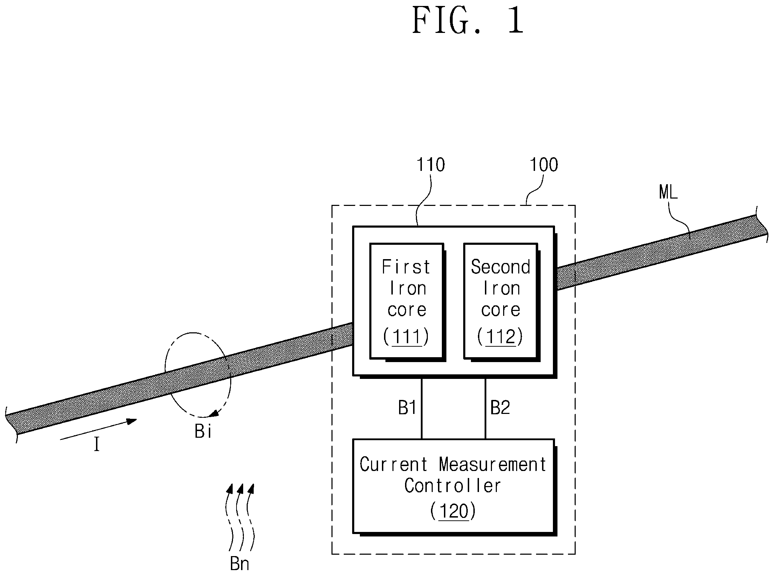

A drawing showing the best mode for carrying out the inventive concept is FIG. 1.

[MODE FOR CARRYING OUT THE INVENTIVE CONCEPT]

Below, embodiments of the inventive concept may be described in detail and clearly to such an extent that an ordinary one in the art easily implements the inventive concept.

FIG. 1 is a diagram illustrating a multi-clamp measurement apparatus according to an embodiment of the inventive concept. Referring to FIG. 1, a multi-clamp measurement apparatus 100 includes a multi-clamp 110 and a current measurement controller 120.

The multi-clamp 110 may be coupled with an outer surface of a conductor ML and may be configured to detect a magnetic field Bi generated by a current flowing through the conductor ML. For example, as illustrated in FIG. 1, when a current "I" flows through the conductor ML, the magnetic field Bi may be generated by the current "I" around the conductor ML. The multi-clamp 110 may have a structure (e.g., a clamp-type structure) to wrap around the conductor ML.

A core included in the multi-clamp 110 may detect a magnitude of a magnetic field that is generated around the conductor ML or exists around the conductor ML. In an embodiment, a core may be formed of a material of great permeability for the purpose of detecting a magnetic field easily. In an embodiment, a magnetic field may be detected through a separate magnetic field sensor such as a hall sensor. Alternatively, a magnetic field may be detected by using a magnetic induction phenomenon through a winding wire wound on a core. Below, for convenience of description, a magnetic field that is generated by the current "I" flowing through the conductor ML is called a "current magnetic field".

The current measurement controller 120 may detect a magnitude of the current "I" flowing through the conductor ML, based on a magnitude of the current magnetic field Bi detected from the multi-clamp 110. For example, in an ideal case, a magnitude of the magnetic field Bi is proportional to a magnitude of the current "I" and is inversely proportional to a distance from the conductor ML. That is, when a magnitude of a magnetic field around the conductor ML is detected, the current measurement controller 120 may detect the magnitude of the current "I" based on the distance from the conductor ML.

In an embodiment, an unintended magnetic field Bn may be generated around the conductor ML. The unintended magnetic field Bn that is not a magnetic field generated by the current "I" flowing through the conductor ML may include a magnetic field existing in a natural state, a magnetic field generated by any other conductor, or a magnetic field generated by any other surrounding factors. Below, the unintended magnetic field Bn is called a "noise magnetic field". The noise magnetic field Bn may be combined with a magnetic field generated by the current "I", and the multi-clamp 110 may detect the combined magnetic field. In this case, a magnitude of the current "I" flowing through the conductor ML may not be accurately detected due to the noise magnetic field Bn.

In an embodiment, when a large current "I" (e.g., tens or hundreds mA, several to tens A, or the like) flows through the conductor ML, because a magnitude of the current magnetic field Bi is significantly greater than the noise magnetic field Bn, an error of a measured current magnitude due to the noise magnetic field Bn may be ignored. However, when a magnitude of a current flowing through the conductor ML is small (i.e., a micro-current flows through the conductor ML), a magnitude of the current magnetic field Bi may be smaller than a magnitude of the noise magnetic field Bn, or the magnitude of the noise magnetic field Bn may be great to such an extent as not to be ignored, compared with the magnitude of the magnetic field Bi generated by the current "I". In this case, the magnitude of the current "I" flowing through the conductor ML may not be accurately measured.

Conventional current measurement apparatuses include a separate shielding device for blocking the noise magnetic field Bn for the purpose of measuring a micro-current. The shielding device is problematic in that the attachment to the conductor ML is difficult and costs of the measurement apparatuses increase.

The multi-clamp measurement apparatus 100 according to the inventive concept may accurately measure a micro-current "I" flowing through the conductor ML without a separate shielding device. For example, the multi-clamp 110 includes a first core 111 and a second core 112. The first and second cores 111 and 112 may be configured to detect a magnetic field around the conductor ML. In this case, each of first and second magnetic fields B1 and B2 detected through the first and second cores 111 and 112 may include the current magnetic field Bi and the noise magnetic field Bn. In an embodiment, a component of the current magnetic field Bi included in the first magnetic field B1 and a component of the current magnetic field Bi included in the second magnetic field B2 may have different directivity. The current measurement controller 120 may detect only a component of the current magnetic field Bi by removing the noise magnetic field Bn based on the first and second magnetic fields B1 and B2. A configuration and a magnetic field detecting scheme of the multi-clamp 110 will be more fully described with reference to the following drawings.

As described above, the multi-clamp measurement apparatus 100 according to the inventive concept may accurately detect a component of the current magnetic field Bi by detecting magnetic fields around the conductor ML through at least two cores (e.g., 111 and 112) and removing a component of the noise magnetic field Bn based on the detected magnetic fields. Accordingly, the multi-clamp measurement apparatus 100 according to the inventive concept may accurately measure a micro-current "I" flowing through the conductor ML without a separate shielding device.

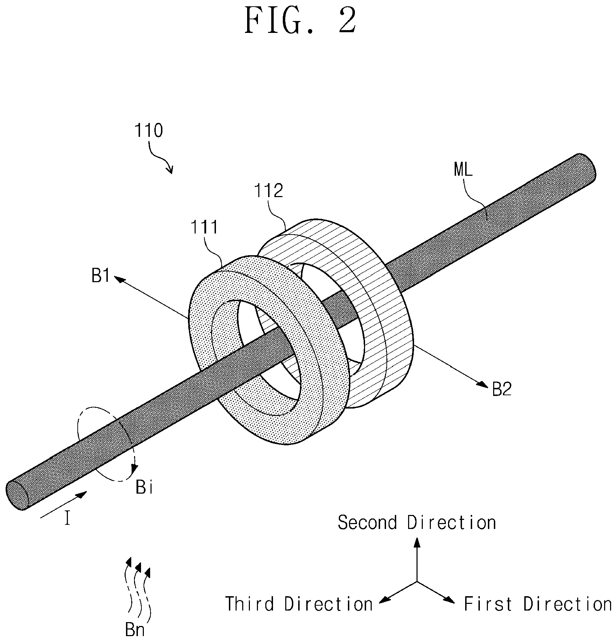

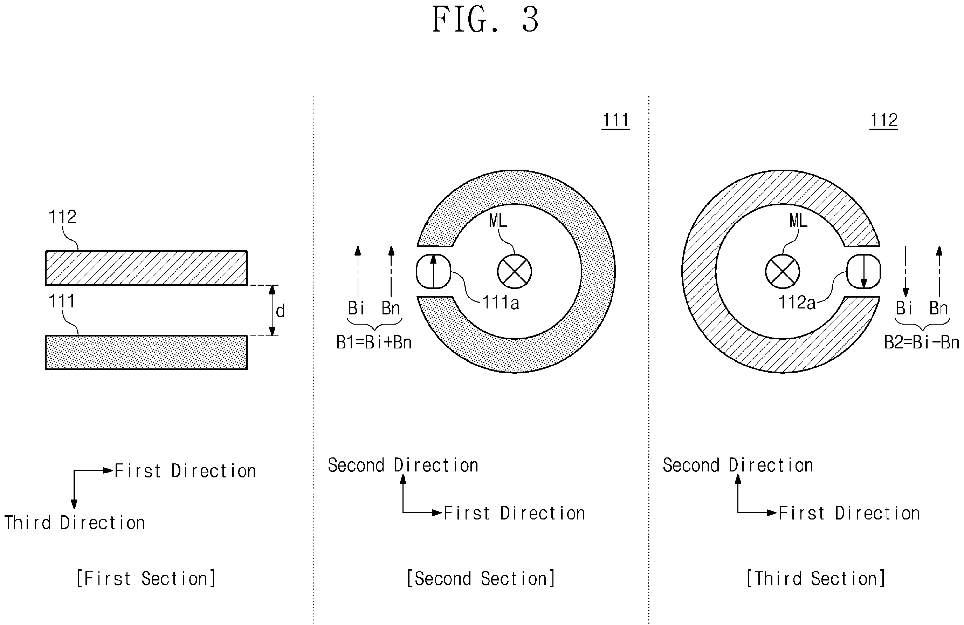

FIGS. 2 and 3 are diagrams illustrating a multi-clamp of FIG. 1 in detail. For brevity of illustration, the first and second cores 111 and 112 included in the multi-clamp 110 are schematically illustrated. However, a configuration of the multi-clamp 110 or the first and second cores 111 and 112 according to the inventive concept is not limited to a configuration or a shape illustrated in FIGS. 2 and 3. Also, for brevity of illustration, components that are unnecessary to describe a configuration of the multi-clamp 110 according to the inventive concept are omitted.

In an embodiment, the current magnetic field Bi and the noise magnetic field Bn may be expressed by a vector value having directivity. However, below, for convenience of description, with regard to the current magnetic field Bi and the noise magnetic field Bn, the directivity is not described in detail, and a configuration of the inventive concept is described simply with reference to a magnitude of a magnetic field. However, this is for convenience of description, and the current magnetic field Bi, the noise magnetic field Bn, or similar other components may actually have directivity and may be obtained through a vector operation.

Below, for convenience of description, a description will be given as the multi-clamp 110, the first and second cores 111 and 112, first and second magnetic sensors 111a and 112a measure a magnetic field and output the measured magnetic field. In this case, to output the measured magnetic field means to output a value corresponding to the measured magnetic field. Also, as described below, that the current measurement controller 120 detects a current based on the measured magnetic fields means that the current measurement controller 120 calculates or draws a magnitude of the current "I" flowing through the conductor ML based on actually measured magnetic fields. The terms and expressions that are described below are for describing an embodiment of the inventive concept easily, and it may be well understood that an actual implementation manner is variously changed or modified.

Referring to FIGS. 1 and 2, the multi-clamp 110 may include the first and second cores 111 and 112. Each of the first and second cores 111 and 112 may be configured to detect a magnetic field around the conductor ML.

The first and second cores 111 and 112 may be arranged in a third direction. For example, a first section of FIG. 3 shows the first and second cores 111 and 112 projected on a plane defined by a first direction and the third direction. As illustrated in the first section of FIG. 3, the first and second cores 111 and 112 may be spaced from each other as much as a given distance "d" in the third direction. In an embodiment, the given distance "d" may be several or tens millimeters (mm). That is, because the first and second cores 111 and 112 are arranged adjacent to each other in a state where the first and second cores 111 and 112 are spaced from each other as much as the given distance "d", the noise magnetic field Bn (e.g., a magnitude and a direction of the noise magnetic field Bn) having an influence on the first core 111 may be substantially equal to the noise magnetic field Bn having an influence on the second core 112.

The first core 111 may include the first magnetic sensor 111a. The first magnetic sensor 111a may detect a first magnetic field B1 being a combined magnetic field of the current magnetic field Bi and the noise magnetic field Bn through the first core 111. The second core 112 may include the second magnetic sensor 112a. The second magnetic sensor 112a may detect a second magnetic field B2 being a combined magnetic field of the current magnetic field Bi and the noise magnetic field Bn through the second core 112.

In an embodiment, the first and second magnetic fields B1 and B2 may have different values depending on positions of the first and second magnetic sensors 111a and 112a. For example, it is assumed that the current "I" flows through the conductor ML in a direction opposite to the third direction. In this case, on a plane defined by the first direction and a second direction, the current magnetic field Bi may be generated around the conductor ML in a clockwise direction. Also, for convenience of description, it is assumed that the noise magnetic field Bn has a directivity corresponding to the second direction.

As illustrated in a second section of FIG. 3, the first magnetic sensor 111a may be positioned on the left (in detail, on the left of the plane defined by the first and second directions) of the first core 111. At the position of the first magnetic sensor 111a, the current magnetic field Bi and the noise magnetic field Bn may have directivity corresponding to the second direction.

The first magnetic sensor 111a may have directivity corresponding to the second direction. That is, the first magnetic sensor 111a may be configured to detect a magnitude of a magnetic field generated in the second direction. In this case, the first magnetic field B1 detected by the first magnetic sensor 111a may be expressed by a sum (i.e., Bi + Bn) of the current magnetic field Bi and the noise magnetic field Bn.

As illustrated in a third section of FIG. 3, the second magnetic sensor 112a may be positioned on the right (in detail, on the right of the plane defined by the first and second directions) of the second core 112. At the position of the second magnetic sensor 112a, the current magnetic field Bi may have directivity corresponding to a direction facing away from the second direction, and the noise magnetic field Bn may have directivity corresponding to the second direction.

The second magnetic sensor 112a may have directivity corresponding to the direction facing away from the second direction. That is, the second magnetic sensor 112a may be configured to detect a magnitude of a magnetic field generated in the direction facing away from the second direction. In this case, the second magnetic field B2 detected by the second magnetic sensor 112a may be expressed by a difference (i.e., Bi - Bn) of the current magnetic field Bi and the noise magnetic field Bn.

As described above, the first magnetic sensor 111a of the first core 111 and the second magnetic sensor 112a of the second core 112 may have a position difference of 180 degrees geometrically mutually with respect to the conductor ML. In other words, the first magnetic sensor 111a of the first core 111 may be positioned to face an opposite surface of the second magnetic sensor 112a of the second core 112 with respect to the conductor ML (or the sensors 111a and 112a are positioned to face each other).

In an embodiment, the first and second magnetic sensors 111a and 112a may be respectively positioned in air gaps or slits of the first and second cores 111 and 112. That is, the air gaps or slits of the first and second cores 111 and 112 may be formed to have a position difference of 180 degrees geometrically. In an embodiment, the positions of the first and second cores 111 and 112 or the air gaps or slits may be relative positions, not absolute positions.

According to Equation 1 below, the current measurement controller 120 may extract only a component of the current magnetic field Bi based on the first and second magnetic fields B1 and B2 thus measured.

[Equation 1]

$$B_i = \frac{B_1 + B_2}{2}$$

In Equation 1, "Bi" represents a current magnetic field, "B1" represents a magnetic field detected by the first magnetic sensor 111a of the first core 111, and "B2" represents a magnetic field detected by the second magnetic sensor 112a of the second core 112. As described above, the first magnetic field B1 may be expressed by the sum (Bi + Bn) of the current magnetic field Bi and the noise magnetic field Bn, and the second magnetic field B2 may be expressed by the difference (Bi - Bn) of the current magnetic field Bi and the noise magnetic field Bn. Accordingly, a component of the noise magnetic field Bn may be removed through Equation 1 based on the first and second magnetic fields B1 and B2, and only a component of the current magnetic field Bi may be extracted. The current measurement controller 120 may detect the current "I" (i.e., a micro-current) flowing through the conductor ML, based on the component of the current magnetic field Bi.

As described above, the multi-clamp measurement apparatus 100 according to the inventive concept may detect the first and second magnetic fields B1 and B2 through the first and second cores 111 and 112 that are positioned adjacent to each other and may remove the noise magnetic field Bn based on the first and second magnetic fields B1 and B2 thus detected. Accordingly, the micro-current "I" flowing through the conductor ML may be accurately measured.

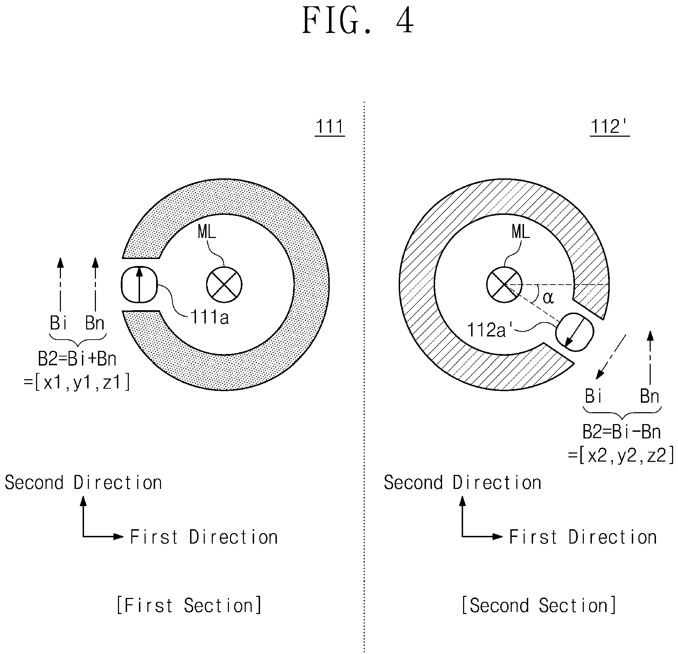

FIG. 4 is a diagram for describing a multi-clamp according to another embodiment of the inventive concept. Components that are unnecessary to describe the configuration of a multi-clamp are omitted for a brief description.

Referring to FIGS. 2 and 4, the multi-clamp 110 may include the first and second cores 111 and 112'. The first and second cores 111 and 112' include first and second magnetic sensors 111a and 112a'. The first and second cores 111 and 112' and the first and second magnetic sensors 111a and 112a' are described with reference to FIGS. 2 and 3, and thus, additional description will be omitted to avoid redundancy.

Unlike the second core 112 of FIG. 3, in the second core 112' of FIG. 4, the second magnetic sensor 112a' may not have a position difference of 180 degrees geometrically with the first magnetic sensor 111a. For example, the first and second magnetic sensors 111a and 112a described with reference to FIG. 3 have a position difference of 180 degrees geometrically. In this case, the noise magnetic field Bn may be removed through the method (i.e., a simple scalar operation) described with reference to Equation 1.

However, as illustrated in a second section of FIG. 4, the second magnetic sensor 112a' may have an angle difference of α geometrically with the second magnetic sensor 112a illustrated in FIG. 3. In this case, a direction of the current magnetic field Bi in a region where the second magnetic sensor 112a' of FIG. 4 is positioned may be different from a direction of the current magnetic field Bi in a region where the second magnetic sensor 112a of FIG. 3 is positioned.

In this case, it may be difficult to remove the noise magnetic field Bn based on the method (i.e., a scalar operation) described with reference to FIG. 3; the noise magnetic field Bn of the above case may be removed through a vector operation. For example, each of the first and second magnetic sensors 111a and 112a' illustrated in FIG. 4 may be configured to detect a direction of a magnetic field as well as a magnitude of the magnetic field. That is, the first and second magnetic sensors 111a and 112a' may be configured to measure a vector value of a magnetic field.

In detail, each of the first and second magnetic sensors 111a and 112a' may include a first sub sensor detecting a magnetic field associated with the first direction, a second sub sensor detecting a magnetic field associated with the second direction, and a third sub sensor detecting a magnetic field associated with the third direction. That is, the first to third sub sensors may have different directivity, and each of the first and second magnetic sensors 111a and 112a' may detect a magnetic field associated with each of the first to third directions.

In this case, the first magnetic field B1 detected by the first magnetic sensor 111a may be a combined magnetic field of the current magnetic field Bi and the noise magnetic field Bn and may be expressed by a vector value of [x1, y1, z1]. The second magnetic field B2 detected by the second magnetic sensor 112a' may be a combined magnetic field of the current magnetic field Bi and the noise magnetic field Bn and may be expressed by a vector value of [x2, y2, z2]. In this case, the current measurement controller 120 may extract the current magnetic field Bi by using Equation 2 below.

[Equation 2]

$$\vec{B_i} = \frac{\vec{B_1} + \vec{B_2}}{2}$$

Referring to Equation 2, $\vec{B_i}$ represents a vector value of a current magnetic field, $\vec{B_1}$ represents a vector value of a first magnetic field, $\vec{B_2}$ represents a vector value of a second magnetic field. As described above, because the noise magnetic field Bn is a magnetic field generated by an external factor, the noise magnetic field Bn may have substantially the same direction and substantially the same magnitude, regardless of a position in the multi-clamp 110. That is, the noise magnetic field Bn may be removed through a vector operation of Equation 2. The current measurement controller 120 may detect the current "I" (i.e., a micro-current) flowing through the conductor ML, based on the current magnetic field Bi from which the noise magnetic field Bn is removed.

As described above, the multi-clamp measurement apparatus 100 according to the inventive concept may detect the first and second magnetic fields B1 and B2 through the first and second cores 111 and 112' and may remove the noise magnetic field Bn based on the first and second magnetic fields B1 and B2 thus detected. In this case, even though the first and second magnetic sensors 111a and 112a' of the first and second cores 111 and 112' have not a position difference of 180 degrees geometrically, the noise magnetic field Bn may be removed based on the vector operation. The current measurement controller 120 may detect the current "I" (in particular, a micro-current) flowing through the conductor ML, based on the current magnetic field Bi from which the noise magnetic field Bn is removed.

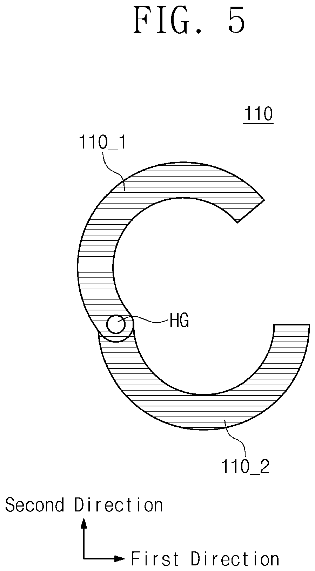

FIG. 5 is a diagram illustrating a configuration of a multi-clamp according to an embodiment of the inventive concept. For brevity of illustration, a plan view of the multi-clamp 110 projected on a plane defined by the first and second directions of FIG. 2 is illustrated.

Referring to FIG. 5, the multi-clamp 110 may include first and second portions 110_1 and 110_2 and a hinge HG. Each of the first and second portions 110_1 and 110_2 may include portions of the first and second cores 111 and 112. For example, the first portion 110_1 may include a portion of the first core 111 and a portion of the second core 112, and the second portion 110_2 may include the remaining portion of the first core 111 and the remaining portion of the second core 112.

The hinge HG may allow the first and second portions 110_1 and 110_2 of the multi-clamp 110 to move independently of each other. For example, the first and second portions 110_1 and 110_2 of the multi-clamp 110 may move with respect to the hinge HG. That is, as illustrated in FIG. 5, the multi-clamp 110 may be mounted on the conductor ML (or to surround the conductor ML) in a state where one ends of the first and second portions 110_1 and 110_2 are separated from each other, and may then perform the above current measuring operation as the first and second portions 110_1 and 110_2 are interconnected (in detail, as illustrated in FIG. 2, such that the multi-clamp 110 wraps around the conductor ML). That is, the multi-clamp 110 may be implemented to be similar to a general clamp meter and may be coupled with the conductor ML without cutting the conductor ML.

In an embodiment, the multi-clamp 110 may be implemented in the form of a circle as illustrated in FIG. 5. However, the inventive concept is not limited thereto. For example, the multi-clamp 110 may be implemented in various shapes that allow a conductive line to be positioned therein (e.g., in the shape of a rectangle, an oval, or a polygon).

In an embodiment, air gaps or slits where the first and second magnetic sensors 111a and 112a are positioned are not clearly illustrated in FIG. 5, but the first and second magnetic sensors 111a and 112a or the air gaps or slits may be disposed at different positions of the first and second portions 110_1 and 110_2.

In an embodiment, the multi-clamp 110 is illustrated in FIG. 5 as one module, but the inventive concept is not limited thereto. For example, as described above, the first and second cores 111 and 112 may be implemented with one module. That is, the first and second cores 111 and 112 may be embedded in the same case to implement one module. Alternatively, the first and second cores 111 and 112 may be implemented with different modules. That is, the first and second cores 111 and 112 may be respectively embedded in different cases to implement different modules. In the latter case, the first and second cores 111 and 112 may include hinges disposed at different positions, respectively.

The above configuration of the multi-clamp 110 and the first and second cores 111 and 112 is for describing an embodiment of the inventive concept easily, and the inventive concept is not limited thereto.

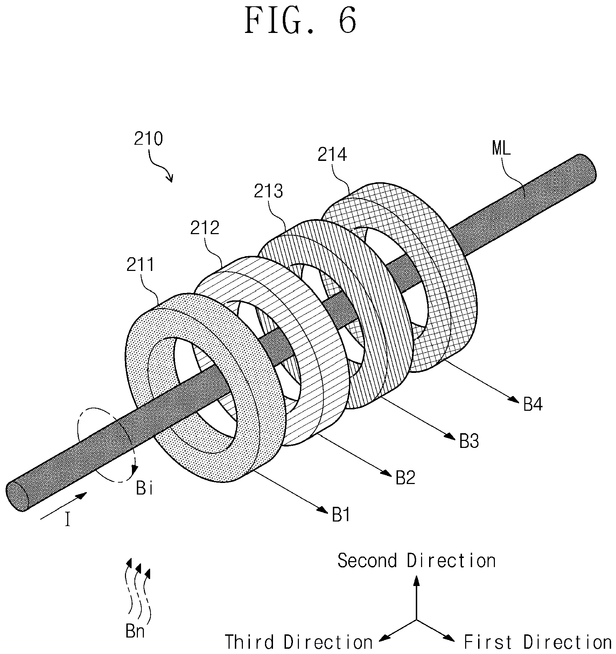

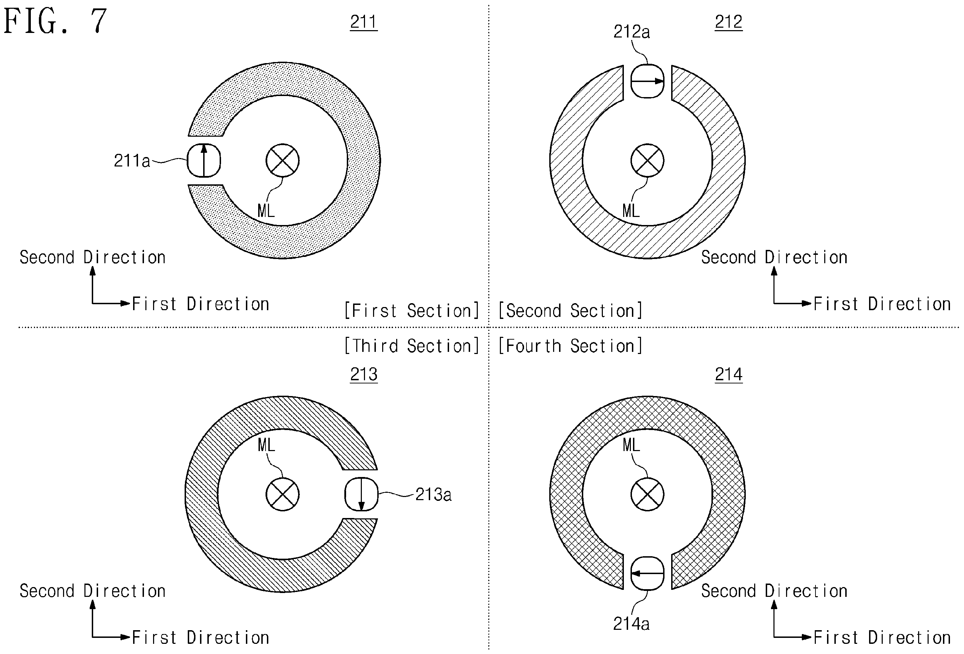

FIGS. 6 and 7 are diagrams illustrating a configuration of a multi-clamp according to an embodiment of the inventive concept. Referring to FIG. 6, a multi-clamp 210 may include first to fourth cores 211 to 214. The first to fourth cores 211 to 214 may detect first to fourth magnetic fields B1 to B4 as described with reference to FIGS. 1 to 4.

For example, as in the description given with reference to FIG. 2, it is assumed that the conductor ML may extend in the third direction, the current "I" may flow in a direction facing away from the third direction, and the noise magnetic field Bn has directivity of the second direction.

In this case, each of the first to fourth cores 211 to 214 may be configured as illustrated in FIG. 7. For example, the first core 211 may include a first magnetic sensor 211a, and the first magnetic sensor 211a may be positioned on the left of the first core 211 (in detail, on the left of a plane defined by the first and second directions). The second core 212 may include a second magnetic sensor 212a, and the second magnetic sensor 212a may be positioned on the top of the second core 212 (in detail, on the top of the plane defined by the first and second directions). The third core 213 may include a third magnetic sensor 213a, and the third magnetic sensor 213a may be positioned on the right of the third core 213 (in detail, on the right of the plane defined by the first and second directions). The fourth core 214 may include a fourth magnetic sensor 214a, and the fourth magnetic sensor 214a may be positioned on the bottom of the fourth core 214 (in detail, on the bottom of the plane defined by the first and second directions).

In other words, the first to fourth magnetic sensors 211a to 214a may be disposed to have a difference of 90 degrees geometrically mutually. In an embodiment, the first to fourth magnetic sensors 211a to 214a may have a difference of 90 degrees geometrically mutually, but the inventive concept is not limited thereto. The first to fourth magnetic sensors 211a to 214a may be disposed at different positions geometrically, and a geometrical position difference is not limited to 90 degrees.

As in the description given with reference to FIGS. 2 to 4, each of the first to fourth magnetic sensors 211a to 214a may be configured to detect the current magnetic field Bi and the noise magnetic field Bn. That is, each of the first to fourth magnetic fields B1 to B4 detected from the first to fourth magnetic sensors 211a to 214a may include the current magnetic field Bi and the noise magnetic field Bn according to a location of each of the first to fourth magnetic sensors 211a to 214a.

In an embodiment, each of the first to fourth magnetic fields B1 to B4 detected from the first and second magnetic sensors 211a to 214a may have a vector value having directivity. As in the description given with reference to FIG. 4, the current measurement controller 120 (refer to FIG. 1) may extract only a component of the current magnetic field Bi by performing a vector operation on the first to fourth magnetic fields B1 to B4 being a vector value such that a component of the noise magnetic field Bn is removed.

In an embodiment, it may be well understood to one skilled in the art that a vector operation for removing the noise magnetic field Bn is performed in various manners. Accordingly, to prevent the technical idea of the inventive concept from being ambiguous, a description associated with the vector operation is omitted.

As described above, a multi-clamp measurement apparatus according to the inventive concept may detect a plurality of magnetic fields through a plurality of cores and may remove a component of the noise magnetic field Bn due to an external factor through a vector operation for the detected magnetic fields. Accordingly, even though a micro-current flows through the conductor ML, because the noise magnetic field Bn is removed, the micro-current may be accurately measured. Also, because a multi-clamp measurement apparatus according to the inventive concept measures a micro-current without a separate shielding device, costs for current measurement decreases.

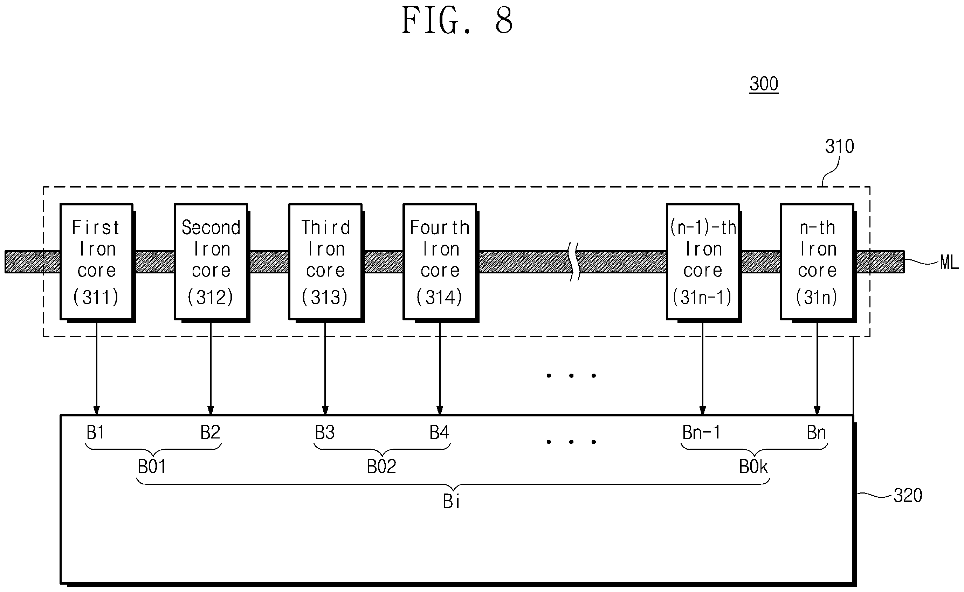

FIG. 8 is a block diagram illustrating a multi-clamp measurement apparatus according to the inventive concept. Referring to FIG. 8, a multi-clamp measurement apparatus 300 includes a multi-clamp 310 and a current measurement controller 320.

The multi-clamp 310 may include first to n-th cores 311 to 31n. The first to n-th cores 311 to 31n may be similar to cores described with reference to FIGS. 1 to 7 in structure. Also, the first to n-th cores 311 to 31n may include magnetic sensors for detecting magnetic fields, respectively; the magnetic sensors may be disposed at different positions geometrically. Geometric positions of the magnetic sensors are similar to those described with reference to FIGS. 1 to 7, and thus, additional description will be omitted to avoid redundancy.

The first to n-th cores 311 to 31n may detect first to n-th magnetic fields B1 to Bn, respectively. The current measurement controller 320 may be configured to detect the current magnetic field Bi by performing an operation (e.g., a scalar operation or a vector operation) on the first to n-th magnetic fields B1 to Bn such that the noise magnetic field Bn is removed.

For example, the current measurement controller 320 may calculate a magnetic field B01 based on the first and second magnetic fields B1 and B2 from the first and second cores 311 and 312 adjacent to each other, the current measurement controller 320 may calculate a magnetic field B02 based on the third and fourth magnetic fields B3 and B4 from the third and fourth cores 313 and 314 adjacent to each other, and the current measurement controller 320 may calculate a magnetic field B0k based on the (n-1)-th and n-th magnetic fields Bn-1 and Bn from the (n-1)-th and n-th cores 31n-1 and 31n adjacent to each other. In an embodiment, the calculated magnetic fields B01 to B0k may include only a component of the current magnetic field Bi. The current measurement controller 320 may calculate a final current magnetic field Bi based on an average of the calculated magnetic fields B01 to B0k and may draw the current "I" based on the final current magnetic field Bi thus calculated.

In an embodiment, the above-described calculation method may be simply an embodiment of the inventive concept and may be changed or modified in various manners. For example, the current measurement controller 320 may be configured to remove the noise magnetic field Bn based on at least three adjacent cores.

As described above, a multi-clamp measurement apparatus according to the inventive concept may include a plurality of cores and may remove the noise magnetic field Bn based on magnetic fields from the plurality of cores. Accordingly, it is possible to measure a micro-current without a separate shielding device.

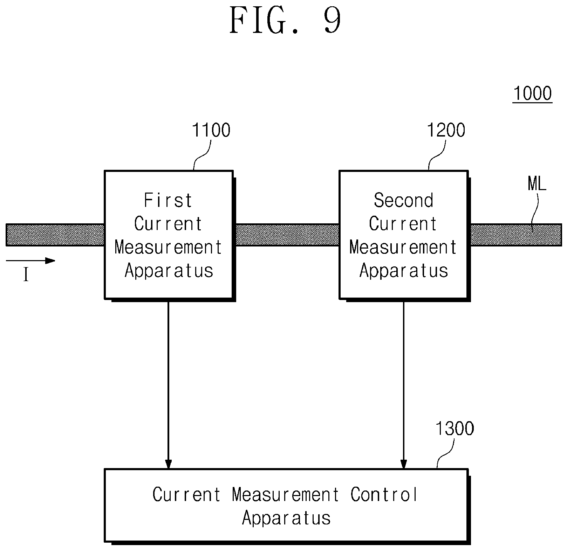

FIG. 9 is a block diagram illustrating current measurement system according to an embodiment of the inventive concept. Referring to FIG. 9, a current measurement system 1000 may include first and second current measurement apparatuses 1100 and 1200 and a current measurement control apparatus 1300.

In an embodiment, each of the first and second current measurement apparatuses 1100 and 1200 may be a multi-clamp measurement apparatus described with reference to FIGS. 1 to 8. Alternatively, the first and second current measurement apparatuses 1100 and 1200 may be a conventional clamp-type current meter (e.g., a current meter including a single core). In an embodiment, the first and second current measurement apparatuses 1100 and 1200 may be disposed adjacent to each other and may be mounted on the conductor ML. The first and second current measurement apparatuses 1100 and 1200 may be configured to output the first and second magnetic fields B1 and B2, respectively.

As described with reference to FIGS. 1 to 8, the current measurement control apparatus 1300 may detect the current magnetic field Bi by removing the noise magnetic field Bn through an operation for the first and second magnetic fields B1 and B2 and may detect the current "I" flowing through the conductor ML based on the detected current magnetic field Bi.

That is, a component of the noise magnetic field Bn may be removed by disposing conventional clamp-type current measurement apparatuses to be adjacent to each other and performing an operation on magnetic fields respectively detected from the conventional clamp-type current measurement apparatuses. In other words, a micro-current flowing through a conductor may be accurately measured without a separate shielding device by applying the technical idea of the inventive concept to the conventional clamp-type current measurement apparatuses.

According to the above embodiments of the inventive concept, a multi-clamp measurement apparatus may accurately measure a micro-current flowing through a conductor by removing a component of the noise magnetic field Bn without a separate shielding device. Accordingly, a multi-clamp measurement apparatus having improved reliability and reduced costs is provided.

The above-mentioned description refers to embodiments for implementing the scope of the inventive concept. Embodiments in which a design is changed simply or which are easily changed may be included in the scope of the inventive concept as well as an embodiment described above. In addition, technologies that are easily changed and implemented by using the above-mentioned embodiments may be also included in the scope of the inventive concept. Therefore, it should be understood that the above embodiments are not limiting, but illustrative.

[INDUSTRIAL APPLICABILITY]

The inventive concept relates a current measurement apparatus, and more particularly, provides a multi-clamp measurement apparatus and a current measurement apparatus.

**Claims**

1. A multi-clamp measurement apparatus comprising:

   a multi-clamp including first and second cores configured to detect first and second magnetic fields around a conductor, respectively; and
   a current measurement controller configured to remove a noise magnetic field around the conductor based on the first and second magnetic fields and to detect a current flowing through the conductor.

2. The multi-clamp measurement apparatus of claim 1, wherein each of the first and second magnetic fields includes a component of a current magnetic field generated by the current flowing through the conductor and a component of the noise magnetic field.

3. The multi-clamp measurement apparatus of claim 2, wherein the first core includes a first magnetic sensor measuring the first magnetic field, and
wherein the second core includes a second magnetic sensor measuring the second magnetic field.

4. The multi-clamp measurement apparatus of claim 3, wherein the first and second magnetic sensors have a geometric position difference of 180 degrees mutually with respect to the conductor.

5. The multi-clamp measurement apparatus of claim 4, wherein a magnitude of the first magnetic field is a sum of a magnetic field of the current magnetic field and a magnitude of the noise magnetic field, and wherein a magnitude of the second magnetic field is a difference between the magnitude of the current magnetic field and the magnitude of the noise magnetic field.

6. The multi-clamp measurement apparatus of claim 3, wherein the first and second magnetic sensors are disposed at different positions with respect to the conductor, and
wherein the current measurement controller is configured to detect the current by performing a vector operation on the first and second magnetic fields such that the noise magnetic field is removed.

7. The multi-clamp measurement apparatus of claim 1, wherein the noise magnetic field includes at least one a magnetic field existing in a natural state, a magnetic field generated by another conductor, or a magnetic field generated by another device.

8. The multi-clamp measurement apparatus of claim 1, wherein the first and second cores are disposed adjacent to each other and are spaced from each other as much as a given distance along the conductor.

9. The multi-clamp measurement apparatus of claim 1, wherein the first and second cores are embedded in one case.

10. A multi-clamp measurement apparatus comprising:

a multi-clamp including a plurality of cores configured to detect magnetic fields around a conductor, respectively; and
a current measurement controller configured to remove a noise magnetic field around the conductor based on the plurality of magnetic fields and to detect a current flowing through the conductor.

11. The multi-clamp measurement apparatus of claim 10, wherein each of the plurality of magnetic fields includes a component of a current magnetic field generated by the current flowing through the conductor and a component of the noise magnetic field.

12. A current measurement system comprising:

a first current measurement apparatus configured to measure a first magnetic field around a conductor;
a second current measurement apparatus spaced from the first current measurement apparatus as much as a given distance, and configured to measure a second magnetic field around the conductor; and
a current measurement controller configured to remove a noise magnetic field around the conductor based on the first and second magnetic fields and to detect a current flowing through the conductor.

# FIG. 1

EP 3 557 267 A1

# FIG. 2

Second Direction

Third Direction

First Direction

# FIG. 3

112

ML
112a
Bn
Bi
B2=Bi−Bn

Second Direction
First Direction
[Third Section]

111

ML
111a
Bn
Bi
B1=Bi+Bn

Second Direction
First Direction
[Second Section]

d
112
111

First Direction
Third Direction
[First Section]

# FIG. 4

<u>111</u>

<u>112'</u>

ML

Bi   Bn

B2=Bi+Bn
=[x1,y1,z1]

111a

ML

α

112a'

Bi   Bn

B2=Bi-Bn
=[x2,y2,z2]

Second Direction

First Direction

[First Section]

Second Direction

First Direction

[Second Section]

# FIG. 5

Second Direction

First Direction

# FIG. 6

# FIG. 7

211

211a

ML

Second Direction

First Direction

[First Section]

212a

212

ML

Second Direction

First Direction

[Second Section]

[Third Section]

[Fourth Section]

213

ML

213a

Second Direction

First Direction

214

ML

214a

Second Direction

First Direction

# FIG. 8

EP 3 557 267 A1

# FIG. 9

1000

1100

1200

ML

First
Current
Measurement
Apparatus

Second
Current
Measurement
Apparatus

I →

1300

Current Measurement Control
Apparatus

# EP 3 557 267 A1

## INTERNATIONAL SEARCH REPORT

International application No.

**PCT/KR2017/014694**

### A. CLASSIFICATION OF SUBJECT MATTER

*G01R 15/18(2006.01)i*

According to International Patent Classification (IPC) or to both national classification and IPC

### B. FIELDS SEARCHED

Minimum documentation searched (classification system followed by classification symbols)
G01R 15/18; G01R 31/00; G01R 21/08; G01R 21/06; G01R 15/20; G01R 22/06

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: magnetic sensor, electric current, measurement, clamp, magnetic field, noise, removal

### C. DOCUMENTS CONSIDERED TO BE RELEVANT

| Category* | Citation of document, with indication, where appropriate, of the relevant passages | Relevant to claim No. |
|---|---|---|
| Y | KR 10-1616854 B1 (FERROTEC CORPORATION) 29 April 2016 <br> See claims 1, 3 and figure 7. | 1-12 |
| Y | JP 2016-090440 A (TOSHIBA CORP.) 23 May 2016 <br> See paragraphs [12]-[23], claim 1 and figures 1-6. | 1-12 |
| A | JP 2012-251993 A (ALPS GREEN DEVICES CO., LTD.) 20 December 2012 <br> See paragraph [4] and claim 2. | 1-12 |
| A | US 8395372 B2 (HARLEV et al.) 12 March 2013 <br> See claim 1 and figures 1-5. | 1-12 |
| A | KR 10-1318984 B1 (ECOSENSE CO., LTD.) 16 October 2013 <br> See claim 1 and figure 3. | 1-12 |

☐ Further documents are listed in the continuation of Box C.  ☒ See patent family annex.

| | |
|---|---|
| * Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| 17 APRIL 2018 (17.04.2018) | **17 APRIL 2018 (17.04.2018)** |

| Name and mailing address of the ISA/KR | Authorized officer |
|---|---|
| Korean Intellectual Property Office <br> Government Complex-Daejeon, 189 Seonsa-ro, Daejeon 302-701, <br> Republic of Korea <br> Facsimile No. +82-42-481-8578 | Telephone No. |

Form PCT/ISA/210 (second sheet) (January 2015)

19

**INTERNATIONAL SEARCH REPORT**
Information on patent family members

International application No.

**PCT/KR2017/014694**

| Patent document cited in search report | Publication date | Patent family member | Publication date |
|---|---|---|---|
| KR 10-1616854 B1 | 29/04/2016 | CN 104169727 A | 26/11/2014 |
| | | CN 104169727 B | 10/10/2017 |
| | | EP 2840400 A1 | 25/02/2015 |
| | | EP 2840400 A4 | 09/12/2015 |
| | | HK 1204806 A1 | 04/12/2015 |
| | | JP 2013-217914 A | 24/10/2013 |
| | | KR 10-2014-0133928 A | 20/11/2014 |
| | | US 2015-0028857 A1 | 29/01/2015 |
| | | US 9448262 B2 | 20/09/2016 |
| | | WO 2013-137253 A1 | 19/09/2013 |
| JP 2016-090440 A | 23/05/2016 | US 2016-0131687 A1 | 12/05/2016 |
| JP 2012-251993 A | 20/12/2012 | CN 102841232 A | 26/12/2012 |
| | | CN 102841232 B | 18/02/2015 |
| | | JP 5834292 B2 | 16/12/2015 |
| | | US 2012-0290240 A1 | 15/11/2012 |
| US 8395372 B2 | 12/03/2013 | AU 2010-313438 A1 | 03/05/2012 |
| | | AU 2010-313438 A1 | 05/05/2011 |
| | | BR 112012010822 A2 | 23/05/2017 |
| | | CA 2786187 A1 | 05/05/2011 |
| | | CA 2965024 A1 | 05/05/2011 |
| | | CN 102713699 A | 03/10/2012 |
| | | CN 102713699 B | 05/11/2014 |
| | | EP 2494392 A1 | 05/09/2012 |
| | | HK 1176410 A1 | 21/08/2015 |
| | | IL 219007 A | 28/06/2012 |
| | | IL 219007 B | 31/07/2016 |
| | | JP 2013-509586 A | 14/03/2013 |
| | | KR 10-1790363 B1 | 20/11/2017 |
| | | KR 10-2012-0093910 A | 23/08/2012 |
| | | MX 2012004742 A | 23/08/2012 |
| | | US 2011-0095749 A1 | 28/04/2011 |
| | | US 2011-0095750 A1 | 28/04/2011 |
| | | US 2013-0033267 A1 | 07/02/2013 |
| | | US 2014-0300341 A1 | 09/10/2014 |
| | | US 2016-0069936 A1 | 10/03/2016 |
| | | US 2017-0108540 A1 | 20/04/2017 |
| | | US 8076925 B2 | 13/12/2011 |
| | | US 9134344 B2 | 15/09/2015 |
| | | US 9341653 B2 | 17/05/2016 |
| | | US 9535097 B2 | 03/01/2017 |
| | | WO 2011-053657 A1 | 05/05/2011 |
| | | WO 2014-014495 A1 | 23/01/2014 |
| KR 10-1318984 B1 | 16/10/2013 | NONE | |